Europäisches Patentamt

(19) **European Patent Office**

Office européen des brevets

(11) Publication number: **0 091 734**

**A1**

(12) **EUROPEAN PATENT APPLICATION**

(21) Application number: **83301419.4**

(22) Date of filing: **15.03.83**

(51) Int. Cl.³: **C 23 C 13/02**
**C 23 C 13/08, C 23 C 13/10**
**C 22 C 1/00**

---

(30) Priority: **06.04.82 GB 8210144**

(43) Date of publication of application:
**19.10.83 Bulletin 83/42**

(84) Designated Contracting States:
**CH DE FR LI SE**

(71) Applicant: **The Secretary of State for Defence in Her Britannic Majesty's Government of The United Kingdom of Great Britain and**
**Northern Ireland Whitehall**
**London SW1A 2HB(GB)**

(72) Inventor: **Bickerdike, Robert Lewis**
**Clays Farm East Worldham**
**Alton Hampshire(GB)**

(72) Inventor: **Goddard, David John**
**34 Edward Road**
**Farnham Surrey(GB)**

(72) Inventor: **Viney, Brian William**
**7 St. Michaels Road**
**Farnborough Hampshire(GB)**

(72) Inventor: **Hughes, Garyth**
**St. Helier Thorn Close**
**Boundstone Farnham Surrey(GB)**

(74) Representative: **Miller, Ronald Anthony et al,**
**Procurement Executive, Ministry of Defence Patents**
**1A4, Room 2014 Empress State Building Lillie Road**
**London SW6 1TR(GB)**

---

(54) **Improvements in or relating to the bulk production of alloys by deposition from the vapour phase and apparatus therefor.**

(57) A process for the bulk production of alloy from the vapour phase and employing a reusable collector is described. Such a collector has an annular chamber between an outer skin member forming a deposition surface and an inner member forming the collector drum main structure, the chamber being substantially coextensive in an axial direction with the drum main structure and is capable of being at least partially filled with a material such that in use that material is liquid.

Suitable materials, depending upon temperature of operation, for filling the annular chamber may include low melting point alloys such as solders or low vapour pressure oils.

./...

Fig.1.

JX/6217

IMPROVEMENTS IN OR RELATING TO THE BULK PRODUCTION OF ALLOYS
BY DEPOSITION FROM THE VAPOUR PHASE AND APPARATUS THEREFOR

This invention relates to the bulk production of alloy material by deposition from the vapour phase and in particular to the removal of deposited alloy from a collector used in such a process.

Presently evaporated alloys are produced by deposition of alloy vapour from an evaporator onto a collector. In the process described in UK Patent Application Number 2079324A the collector in the form of a rotatable drum is positioned above the evaporator. Both the collector and the evaporator are housed within a vacuum or low pressure chamber. An unacceptable temperature rise at the surface of the deposited alloy is prevented by a combination of controlled cooling via the internal surface of the collector and also by control of the speed of rotation of the collector itself so that a particular area of the collector surface is not exposed over-long to the evaporating metal. Under conditions of controlled cooling and speed of rotation the collector is continuously rotated above the evaporator until the required thickness of deposit is obtained. The collector is then removed from the vacuum chamber and the collector itself machined from the deposited alloy using a boring tool. The remaining deposit is then cut into arcuate plates which may be formed into sheets by conventional metal working processes.

It will be appreciated that a major problem in such a process lies with the complete destruction of the collector.

If the type of collector chosen for the process does not rely on gas-gap cooling assemblies for temperature control, but on more conventional means such as pipes carrying cooling fluid for example, then the interior of the collector drum will be far from a smooth bored cylinder and will in fact represent a major item of expenditure in terms of added value in machining time on attachment points for heaters, cooling pipes and heat conduction devices etc.

Methods of producing a reuseable collector are described in copending UK Patent Application Number 8137546 which describes the use of a low melting point parting agent such as solder to enable the deposited alloy to be separated from the collector without the complete destruction of that collector.

The method described in this copending application requires close temperature control to prevent localised or instantaneous temperature rises as would be caused by localised interruptions of the thermal path between the deposited alloy surface and the interior cooling means.

The present invention provides a reuseable collector for a process for the production of bulk alloys from the vapour phase wherein such close temperature control is not required whilst still providing a collector which is reuseable and which may be removed and reinstalled within the vacuum chamber without a requirement to completely dismantle and refit the supporting shafts, drive units and temperature control equipments.

According to one aspect of the present invention a collector for use in a process for the production of a bulk alloy by deposition from the vapour phase has an annular chamber between an outer skin member forming a deposition surface and an inner member forming the collector drum main structure, the chamber being substantially coextensive in an axial direction with the drum main structure and is capable of being at least partially filled with a material such that in use that material is liquid.

According to a second aspect of the present invention a process for the production of bulk alloy by deposition from the vapour phase comprises the steps of producing a drum shaped collector having an outer removable skin forming a deposition surface, said skin being separated from the main drum structure by an annular chamber, causing the chamber to be at least partially filled with a material such that in use that material is liquid, depositing an alloy from the vapour phase onto the outer surface of the removable skin, removing the outer skin from the main drum structure and further processing the deposited alloy thereon

According to a preferred embodiment of the present invention a material used to fill the annular chamber may be a low melting point metal or alloy such as, for example, a solder alloy based on the lead-tin system and having a melting point of less than about 200°C.

According to a feature of the present invention a metal used in the annular chamber may be one having a minimal metallurgical reaction with the materials used to construct the collector members with which the molten metal comes into contact.

A particular advantage of the present invention is that a continuous thermal path is always available for cooling in the area which receives the greatest heat flux, that is at the lower region of the collector immediately above the evaporator source where the metal vapour is being deposited. By controlling the extent to which the annular chamber in the collector is filled, cooling may be substantially restricted only to that portion of the collector where a thermal path exists by virtue of the presence of the molten metal and thereby no more heat need be withdrawn from the system in excess of that which is necessary to prevent overheating of the deposited alloy.

4

In order that the present invention may be more fully understood a specific embodiment will now be described by way of example only with reference to the following figures:

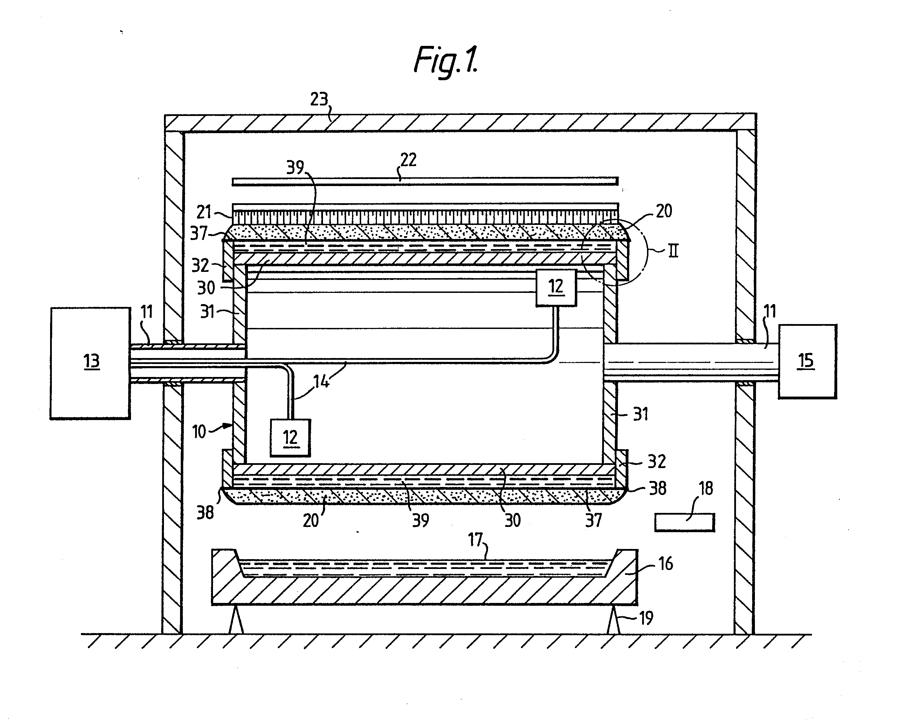

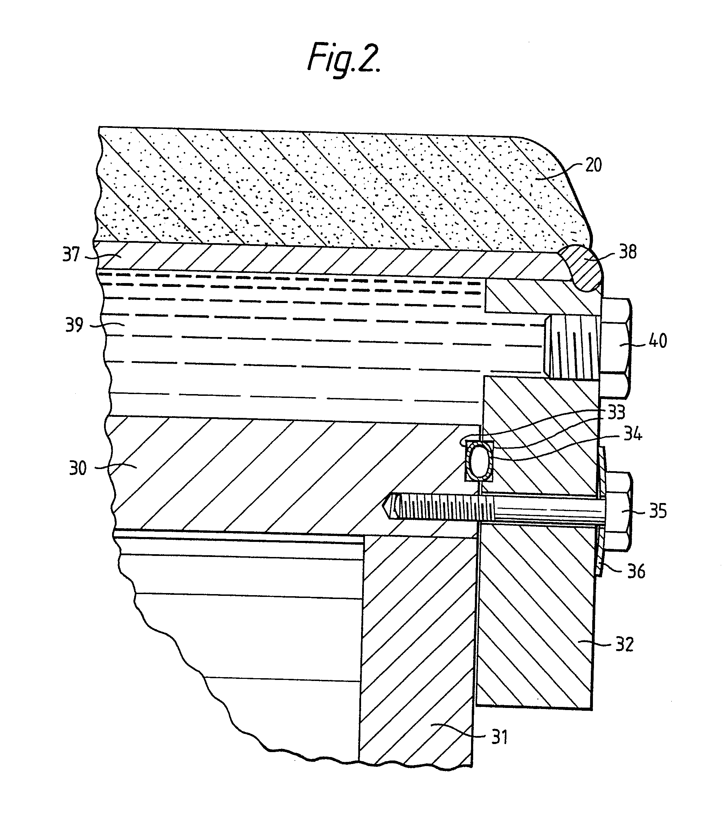

Figure 1 which shows a schematic sectional elevation of a drum type collector positioned within the deposition apparatus; and Figure 2 which shows the detail denoted by "II" of Figure 1.

Referring now to figure 1 a collector drum assembly 10 is mounted on stub shafts 11 and includes gas-gap cooling assemblies 12 connected to a temperature control unit 13 by pipes 14. The drum assembly 10 is rotateable by drive means 15 above an evaporator crucible 16 containing molten alloy 17 of the required composition, the alloy being melted and maintained at the required temperature by an electron-beam gun and scanning equipment 18. The evaporator crucible 16 is supported on adjustable height jacks 19.

Metal vapour from the molten alloy 17 is deposited on the surface of the drum assembly 10 to form the deposited alloy layer 20. Shadowing effects and voids due to the effects of growing crystal facets are avoided by continuous peening of the deposited alloy surface 20 with a rotary flail arrangement 21.

Initial heating of the drum assembly 10 surface is achieved by a radiant heater 22 (which does not lie in the plane of the drawing).

Except for the various control and drive systems the apparatus is contained within a vacuum chamber 23.

Referring now also to figure 2 the drum main structure comprises a substantial aluminium alloy cylindrical machining 30 and end plates 31 also of aluminium alloy, the end plates 31 being sealably connected to the cylindrical machining 30. At each end of the main drum structure formed by the cylinder 30 and end plates 31 are machined aluminium alloy circular flange plates 32, the cylinder 30 and flange plates 32 having cooperating circular grooves 33 for the retention of a resilient

5

flexible metal seal 34. The flange plates 32 are affixable to the cylinder 30 by bolts 35 having also disc springs 36 to provide a resilient mounting for the flange plates 32 and capable of accommodating thermal expansion effects.

Between the outer peripheries defined by the two flange plates 32 there is welded an aluminium alloy sheet 37 such that the sheet forms the outer deposition surface of the collector. The sheet 37 is seam welded to the outer peripheries of each flange plate 32 by MIG welding forming a weld bead 38. Where the two ends of the sheet 37 abut in the axial direction this joint is also MIG welded and ground approximately level. The hollow annular chamber defined by the cylinder 30, end flanges 32 and welded sheet 37 is filled with molten lead-tin eutectic alloy (lead-61.9 wt% tin, M.Pt 183°C) 39. A screw threaded plug 40 is provided in the flange plate 32 to assist in filling and later in draining off of the molten solder alloy 39.

In operation the collector drum assembly 10 described above is rotated above the molten alloy vapour source 17. The vapour is deposited on the collector surface formed by the welded sheet 37, because the molten alloy 39 is always in the lower part of the annular chamber described above, thermal contact, and therefore, heat conduction is always achieved at the hottest area of the deposition surface where the cooling requirement is critical.

Once a sufficiently thick deposit 20 of approximately 50 mm has been achieved the collector assembly 10 is removed from the vacuum chamber 23. The molten alloy 39 is run out of the collector before it solidifies by way of the plug 40 orifice. The drum assembly 10 is set up on a special fixture designed to rotate the drum 10 about its axis, the two weld beads 38 are machined away by a cutting tool set up on the fixture. The bolts 35 and disc springs 36 securing the flang plates 32 to the cylinder 30 are removed thus allowing the flange plates 32

6

to be withdrawn.    The outer sheet 37 and deposit 20 are now free to be removed from the drum for further processing into alloy plate.

It is not essential that the annular chamber is full of molten solder alloy.    By running the apparatus with the annular chamber only partially full a more uniform temperature may be maintained within the deposited alloy as cooling will only occur to a significant extent where there is thermal contact between the inner and outer walls of the collector.

Because the gap in the annular chamber between the inner cylinder and outer sheet is not critical the machined end flange plates may be remachined on the outer circumference and reused a number of times thus making the overall economics of the process more favourable.

Although lead-tin eutectic has been specified above, any metal or alloy which melts below the operating temperature of the process and does not have a significant metallurgical interaction with the materials used for the construction of the drum may be used.

Where the temperature of operation of the process allcws, alternative materials to molten metal may be used in the annular chamber.  For example, a low vapour pressure oil such as that used in diffusion pumps may be employed for lower temperature operation and where the requirements of adequate thermal conductivity allow its use.

MIG welding of the outer skin member has been specified in the embodiment described above, however, it will be evident to those skilled in the art that any welding process or processes appropriate to the materials employed for drum construction may be used.

Further refinements may be employed in the drum construction for example, axial or circumferential ribs may be machined on or attached to the outer surface of the inner drum member in order to lend additional support to the outer welded sheet member during mechanical working of the initial deposited metal. Any such ribs employed in the construction may have suitable channels cut in them in order to minimise the restriction of flow of the molten metal within the annular chamber during rotation of the collector.

CLAIMS

1    A reusable collector for use in a process for the bulk production of alloy by deposition from the vapour phase characterised in that the collector comprises an annular chamber between an outer cylindical skin member constituting a deposition surface on the outer surface thereof and an inner cylindrical member forming the collector main drum structure, the annular chamber being substantially coextensive in an axial direction with the drum main structure and capable of being at least partially filled with a material such that in use that material is liquid.

2    A process for the bulk production of alloy by deposition from the vapour phase characterised in that the process comprises the steps of;

producing a drum shaped collector having an outer removable skin constituting a deposition surface, the skin being separated from the drum main structure by an annular chamber,

causing the chamber to be at least partially filled with a material such that in use that material is liquid, depositing an alloy from the vapour phase onto the outer removable skin and

on completion of deposition of alloy vapour removing the outer skin from the drum main structure and further processing the deposited alloy.

3    A reusable collector as claimed in claim 1 characterised in that the material used to fill the annular chamber is a low melting point alloy.

4    A removable collector as claimed in claim 1 characterised in that the material used to fill the annular chamber is a low vapour pressure oil.

2

5    A reuseable collector as claimed in claim 1 characterised
in that the outer cylindrical skin is supported by axial and/
or circumferential ribs on the outer surface of the inner
drum structure.

Fig.1.

Fig.2.

### European Patent Office

## EUROPEAN SEARCH REPORT

| DOCUMENTS CONSIDERED TO BE RELEVANT | | | EP 83301419.4 |
|---|---|---|---|

| Category | Citation of document with indication, where appropriate, of relevant passages | Relevant to claim | CLASSIFICATION OF THE APPLICATION (Int. Cl. ³) |
|---|---|---|---|
| D,X | GB - A - 2 079 324 (THE SECRETARY OF STATE FOR DEFENCE) <br> * Fig.; claims * <br> ---- | 1,2 | C 23 C 13/02 <br> C 23 C 13/08 <br> C 23 C 13/10 <br> C 22 C 1/00 |

**TECHNICAL FIELDS SEARCHED (Int. Cl. ³)**

C 23 C
C 22 C

The present search report has been drawn up for all claims

| Place of search | Date of completion of the search | Examiner |
|---|---|---|
| VIENNA | 21-06-1983 | SLAMA |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03 82